## Europäisches Patentamt
## European Patent Office
## Office européen des brevets

(19)

(11) **EP 0 695 947 B1**

(12) **EUROPÄISCHE PATENTSCHRIFT**

(45) Veröffentlichungstag und Bekanntmachung des Hinweises auf die Patenterteilung:
**14.11.2001 Patentblatt 2001/46**

(51) Int Cl.7: **G01R 33/341**, G01R 33/565

(21) Anmeldenummer: **95202082.4**

(22) Anmeldetag: **31.07.1995**

(54) **MR-Verfahren zur Bestimmung der Kernmagnetisierungsverteilung mit einer Oberflächenspulen-Anordnung**

MR method for determining the distribution of nuclear magnetization with a surface coil arrangement

Procédé de résonance magnétique pour déterminer la distribution de la magnétisation nucléaire avec un dispositif de bobine de surface

(84) Benannte Vertragsstaaten:
**DE FR GB NL**

(30) Priorität: **03.08.1994 DE 4427429**

(43) Veröffentlichungstag der Anmeldung:
**07.02.1996 Patentblatt 1996/06**

(73) Patentinhaber:
• **Philips Corporate Intellectual Property GmbH 52064 Aachen (DE)**
Benannte Vertragsstaaten:
**DE**
• **Koninklijke Philips Electronics N.V. 5621 BA Eindhoven (NL)**
Benannte Vertragsstaaten:
**FR GB NL**

(72) Erfinder:
• **Jensen, Jens-Dye, Dr., c/o Philips D-22335 Hamburg (DE)**

• **Carlsen, Ingwer Curt, Dr., c/o Philips D-22335 Hamburg (DE)**

(74) Vertreter: **Hartmann, Heinrich, Dipl.-Ing. et al Philips Corporate Intellectual Property GmbH, Habsburgerallee 11 52064 Aachen (DE)**

(56) Entgegenhaltungen:
**EP-A- 0 187 389**     **EP-A- 0 271 123**
**EP-A- 0 412 824**     **EP-A- 0 414 474**
**EP-A- 0 635 727**     **GB-A- 2 266 775**

• **MEDICAL PHYSICS., Bd.15, Nr.2, März 1988, NEW YORK US Seiten 241 - 245 W.W. BREY ET AL. 'CORRECTION FOR INTENSITY FALLOFF IN SURFACE COIL MAGNETIC RESONANCE IMAGING'**

**Beschreibung**

Die Erfindung betrifft ein MR-Verfahren zur Bestimmung der Kernmagnetisierungsverteilung in einem Untersuchungsbereich, bei dem die bei einer MR-Untersuchung mit Hilfe einer mindestens eine Spule enthaltenden Oberflächenspulen-Anordnung mit örtlich inhomogener Emp findlichkeit gewonnenen Bild-Daten aufgrund von Hilfswerten korrigiert werden, die aus den mit Hilfe einer Körper-Spulenanordnung mit örtlich zumindest näherungsweise homogener Empfindlichkeit gewonnenen Daten abgeleitet werden.

Die Bestimmung der Kernmagnetisierungsverteilung in einem Untersuchungsbereich mittels einer aus mindestens einer, in der Praxis aber meist aus mehreren Oberflächenspulen bestehenden Oberflächenspulen-Anordnung hat den Vorteil, daß das Signal/Rauschverhältnis wesentlich besser ist als bei Spulen, die Kernresonanzsignale aus dem gesamten Untersuchungsbereich empfangen können; die letztgenannten Spulen, die in der Praxis auch als Ganzkörperspulen oder als Volumenspulen bezeichnet werden, werden im folgenden als "Körper-Spulenanordung" bezeichnet.

Ein Nachteil bei der Erzeugung von MR-Bildern mit Hilfe einer Oberflächenspulen-Anordnung besteht jedoch darin, daß die Empfindlichkeit (die - ortsabhängige - Empfindlichkeit einer MR-Spule ist definiert als der Quotient aus der magnetischen Induktion an einem bestimmten Ort und aus dem Strom in der Spule, der diese magnetische Induktion an diesem Ort hervorruft) örtlich inhomogen ist, d.h. davon abhängt, wo im Untersuchungsbereich das MR-Signal auftritt. Die mit einer Oberflächenspulen-Anordnung erzeugten Daten müssen daher korrigiert werden, um die ortsabhängigen Empfindlichkeitsunterschiede auszugleichen.

Es ist zu diesem Zweck bekannt, zusätzlich eine Körperspulen-Anordnung zu verwenden. Da diese eine örtlich homogene Empfindlichkeit hat, können mit Hilfe des von der Körperspule erzeugten MR-Bildes die Daten für das MR-Bild korrigiert werden, das aus den von der Oberflächenspulen-Anordnung empfangenen MR-Signalen gebildet wird.

Bei einem ersten Verfahren dieser Art, das aus der EP-A 412 824 sowie einem Aufsatz von Okamoto et al, SMRM 11th Annual Meeting, p. 4042, 1992, bekannt ist, werden aus den MR-Signalen, die die Körperspulen-Anordnung gleichzeitig mit der Oberflächenspulen-Anordnung aufnimmt, Hilfswerte zur Korrektur der ortsabhängigen Empfindlichkeit der Oberflächenspulen-Anordnung -Anordnung abgeleitet.

Voraussetzung für das Funktionieren dieses Verfahrens ist, daß zwischen den einzelnen Spulen der Oberflächenspulen-Anordnung einerseits und der Körperspulen-Anordnung andererseits keine induktive Kopplung besteht. Diese Voraussetzung ist in der Praxis allenfalls für Spezialfälle erfüllbar.

Bei einem anderen, in der EP-A-271 123 beschriebenen, Verfahren werden die MR-Untersuchung mit einer eine einzige Spule umfassenden Oberflächenspulen-Anordnung -Anordnung und eine MR-Hilfsmessung (obwohl es sich auch dabei um eine MR-Untersuchung handelt, wird dafür hierbei und im folgenden der Begriff "MR-Hilfsmessung" benutzt) mit der Körperspulen-Anordnung zeitlich getrennt voneinander ausgeführt. Auch wenn die MR-Hilfsmessung mit geringerer räumlicher Auflösung durchgeführt werden kann als die MR-Untersuchung mit der Oberflächenspulen-Anordnung, müssen die beiden MR-Verfahren das gleiche Kontrastverhalten liefern. Dies führt dazu, daß auch die MR-Hilfsmessung mit der Körperspulen-Anordnung je nach Aufnahmeverfahren relativ lange dauert. Darüberhinaus führen zeitlich schnell erfolgende kleinräumige Veränderungen in dem von den beiden Spulen-Anordnungen aufgenommenen Bereich, wie sie beispielsweise bei MR-Angiographien auftreten können, zum Versagen der Methode, weil bereits der kleinste räumliche Versatz zwischen den beiden Aufnahmen zu Fehlern führt.

Aufgabe der vorliegenden Erfindung ist es, ein Verfahren der eingangs genannten Art weiter auszugestalten. Diese Aufgabe wird erfindungsgemäß dadurch gelöst, daß zusätzlich zur MR-Untersuchung je eine MR-Hilfsmessung mit der Oberflächenspulen-Anordnung und mit der Körper-Spulenanordnung erfolgt, daß die beiden MR-Hilfsmessungen zeitlich getrennt voneinander und von der MR-Untersuchung erfolgen, daß während der beiden MR-Hilfsmessungen die auf den Untersuchungsbereich einwirkenden Magnetfelder den gleichen zeitlichen Verlauf haben und daß die Hilfswerte aus den bei den beiden MR-Hilfsmessungen gewonnen Daten abgeleitet werden.

Bei der Erfindung werden also neben der MR-Untersuchung mit der Oberflächenspulen-Anordnung eine (erste) MR-Hilfsmessung mit der Oberflächenspulen-Anordnung und eine (zweite) MR-Hilfsmessung mit der Körperspulen-Anordnung durchgeführt, wobei es wesentlich ist, daß die während der beiden MR-Hilfsmessungen auf den Untersuchungsbereich einwirkenden Magnetfelder den gleichen zeitlichen Verlauf haben, d.h., daß dieselben Sequenzen auf diesen Bereich einwirken. Gegenüber der EP-B 271 123, die nur eine MR-Untersuchung und eine MR-Hilfsmessung benötigt, erscheint dies zunächst als ein zeitlicher Mehraufwand. Da die beiden MR-Hilfsmessungen jedoch nicht das gleiche Kontrastverhalten liefern müssen wie die MR-Untersuchung, können hierfür sehr schnelle MR-Verfahren angewandt werden. Darüberhinaus ist für die MR-Hilfsmessungen nur ein geringes räumliches Auflösungsvermögen erforderlich, was die Meßzeit für die beiden MR-Hilfsmessungen noch weiter reduziert. Es gibt auch keine Schwierigkeiten, wenn mit der MR-Untersuchung das Gefäßsystem eines Menschen abgebildet werden soll, weil die beiden MR-Hilfsmessungen das Gefäßsystem nicht abbilden müssen (wohl aber den Bereich, in dem diese Gefäße liegen), so daß die im Gefäßsystem zwischen den beiden MR-Hilfsmessungen erfolgenden Lageänderungen keinerlei Einfluß auf die Kalibrierung haben.

Nach einer Weiterbildung der Erfindung erfolgt die Korrektur der bei der MR-Untersuchung gewonnenen Bilddaten dadurch, daß aus den bei der MR-Hilfsmessung mit der Oberflächenspulen-Anordnung einerseits und aus den bei der MR-Untersuchung andererseits gewonnenen MR-Bilddaten MR-Überlagerungsbilder errechnet werden, die in gleicher Weise von der ortsabhängigen Empfindlichkeit der Oberflächenspulen-Anordnung abhängen, und daß aus der Relation des aus der MR-Hilfsmessung erhaltenen MR-Überlagerungsbildes zu dem aus der MR-Hilfsmessung mit der Körperspulen-Anordnung gewonnenen MR-Bild Hilfswerte gewonnen werden, mittels derer das aus der MR-Untersuchung abgeleitete MR-Überlagerungsbild korrigiert wird.

Eine bevorzugte Ausgestaltung, die zu einem optimalen Signal/Rausch-Verhältnis führt, sieht vor, daß die MR-Überlagerungsbilder durch gewichtete Summierung der für die einzelnen Spulen der Oberflächenspulen-Anordnung ermittelten MR-Bilder gebildet werden, wobei die Gewichtungsfaktoren, mit denen die MR-Bilddaten der einzelnen MR-Bilder in die Summierung eingehen, aus der Relation der bei den beiden MR-Hilfsmessungen jeweils für den gleichen Bildpunkt gewonnenen MR-Bilddaten abgeleitet werden.

Eine MR-Anordnung zur Durchführung des erfindungsgemäßen Verfahrens, umfassend

a) eine mindestens eine Spule umfassende Oberflächenspulen-Anordnung
b) eine Körperspulen-Anordnung mit örtlich zumindest näherungsweise homogener Empfindlichkeit
c) Verarbeitungsmittel zur Erzeugung von MR-Bildern aus den von der Oberflächenspulen-Anordnung und von der Körperspulen-Anordnung empfangenen MR-Signalen sowie zum Ableiten von Hilfswerte aus den MR-Bildern
d) programmierbare Steuermittel zum Steuern des zeitlichen Verlaufs der auf den Untersuchungsbereich einwirkenden Magnetfelder und der MR-Signalverarbeitung, ist so gestaltet, daß

die Steuermittel so programmiert sind, daß zeitlich voneinander getrennt eine MR-Untersuchung und eine MR-Hilfsmessung mit der Oberflächenspulen-Anordnung und eine MR-Hilfsmessung mit der Körperspulen-Anordnung durchgeführt werden, wobei die während der beiden MK-Hilfsmessungen auf den Untersuchungsbereich einwirkenden Magnetfelder den gleichen zeitlichen verlauf haben und daß die Verarbeitungsmittel aus den bei den MR-Hilfsmessungen gewonnenen Daten Hilfswerte gewinnen, mit denen die bei der MR-Untersuchung gewonnenen Bild-Daten korrigiert werden.

In weiterer Ausgestaltung der Erfindung ist dabei vorgesehen, daß die Oberflächenspulen-Anordnung und die Körperspulen-Anordnung in einem Empfangs-Modus, in dem sie MR-Signale aufnehmen können, und in einem Entkopplungs-Modus betreibbar sind, in dem sie keine MR-Signale aufnehmen können, und daß die Moden durch die Steuermittel so gesteuert werden, daß die Körperspulen-Anordnung im Entkopplungsmodus betrieben wird, wenn die Oberflächenspulen-Anordnung im Empfangs-Modus betrieben wird - und umgekehrt.

Die Erfindung wird nachstehend anhand der Zeichnungen näher erläutert. Es zeigen

Fig. 1      ein Blockschaltbild eines MR-Untersuchungsgerätes, das die Erfindung beinhalten kann,
Fig. 2      eine Darstellung einer Körperspulen-Anordnung und einer Oberflächenspulen-Anordnung,
Fig. 3      den zeitlichen Verlauf verschiedener Signale bei einer MR-Untersuchung und
Fig. 4      die zeitliche Abfolge der MR-Untersuchung und der MR-Hilfsmessungen

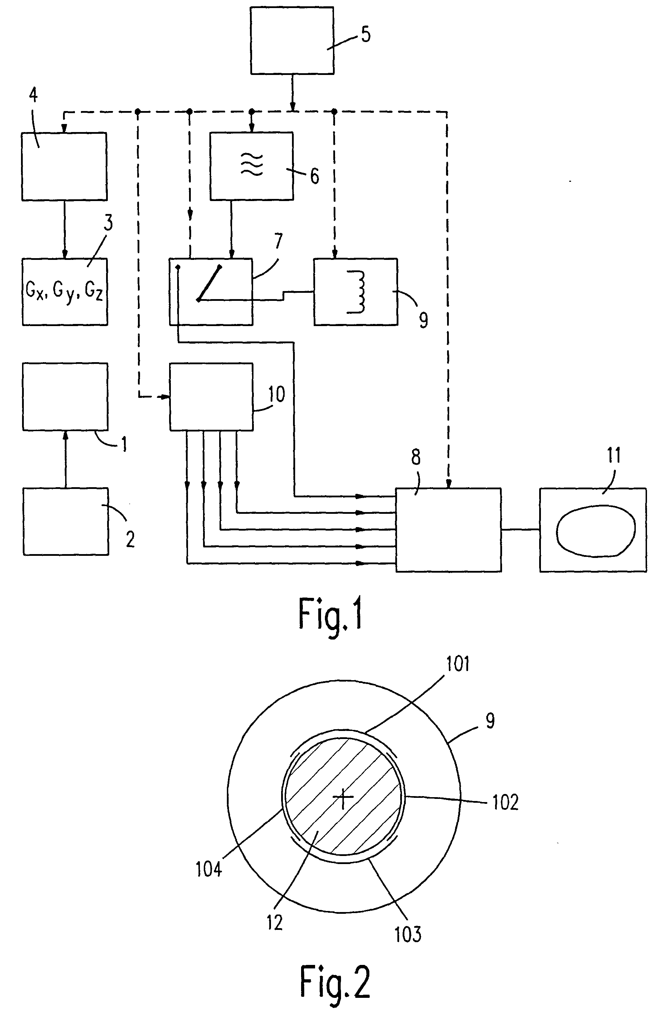

In dem in Fig. 1 schematisch dargestellten Blockschaltbild ist mit 1 ein vorzugsweise supraleitender Magnet bezeichnet, der in einem Untersuchungsbereich, in dem sich ein Patient befinden kann, ein stationäres homogenes Magnetfeld erzeugt. Der dafür erforderliche Strom wird von einer Einheit 2 geliefert. Mit 3 ist eine Gradientenspulen-Anordnung bezeichnet, mit der ein magnetisches Gradientenfeld erzeugt werden kann, das in Richtung des stationären Magnetfeldes verläuft und dessen Gradient entweder in der gleichen Richtung oder in zwei dazu und zueinander senkrechten Richtungen verläuft. Die Ströme hierfür werden von einer Treiberschaltung 4 geliefert, wobei der zeitliche Verlauf der Ströme von einer Steuereinheit 5 gesteuert wird, die mittels eines geeignet programmierten Prozessors realisiert werden kann.

Außerdem ist ein Hochfrequenzgenerator 6 vorgesehen, der impulsweise Schwingungen mit der Larmorfrequenz des Spin-Systems erzeugen kann. Eine Sende/Empfangs-Umschalteinheit 7 verbindet eine Körperspulen-Anordnung 9 wahlweise mit einer Empfängereinheit 8 oder mit dem Hochfrequenzgenerator 6. Die üblicherweise zylinderförmige Körperspulen-Anordnung umschließt bei einer MR-Untersuchung den Körper des Patienten auf einer bestimmten Länge und erzeugt in diesem ein im wesentlichen homogenes Hochfrequenz-Magnetfeld. Darüberhinaus ist eine aus mehreren Oberflächenspulen bestehende Oberflächenspulen-Anordnung 10 vorgesehen.

Die Einheiten 6 bis 10 werden von der Steuereinheit 5 gesteuert. Im Sendebetrieb befindet sich die Sende/Empfangs-Umschalteinheit 7 in der in der Zeichnung dargestellten Stellung, so daß die vom Hochfrequenzgenerator 6 erzeugten Schwingungen der Körperspulen-Anordnung 9 zugeführt werden, die im Untersuchungsbereich ein Hochfrequenzmagnetfeld erzeugt. Während des Sendebetriebes ist die Oberflächenspulen-Anordnung unwirksam, beispielsweise dadurch, daß jede einzelne Spule diese Anordnung während des Sendebetriebes verstimmt ist.

Wenn die Sende/Empfangs-Umschalteinheit 7 von der Steuereinheit 5 in die andere Schalterstellung umgeschaltet ist, können mit der MR-Spulenanordnung 9 die im Untersuchungsbereich entstehenden MR-Signale empfangen werden. Anstelle einer als Sende- und als Empfangsspule wirksamen Körperspulen-Anordnung können für den Sendebetrieb und für den Empfangsbetrieb gesonderte Spulen vorgesehen sein. Wichtig ist dabei, daß auch die für den Empfangsbetrieb vorgesehene Körperspulen-Anordnung eine räumlich zumindest näherungsweise konstante Empfindlichkeit hat.

Die Empfängereinheit 8 enthält für jede Spule der Oberflächenspulen-Anordnung und für die Körperspulen-Anordnung 9 je einen Kanal, in dem das von der jeweiligen Spule empfangene MR-Signal verstärkt, in einen niedrigeren Frequenzbereich transponiert und digitalisiert wird und in dem aus den digitalisierten MR-Signalen jeweils ein MR-Bild rekonstruiert werden kann. Die in der Empfänger- und Verarbeitungseinheit 8 erzeugten MR-Bilder sind auf einem Monitor 11 darstellbar.

Von den Spulen-Anordnungen 9 und 10 ist nur eine wirksam. Wenn die MR-Signale von der Körperspulen-Anordnung 9 empfangen werden sollen, werden die Spulen der Oberflächenspulen-Anordnung 10 durch die Steuereinheit 5 verstimmt, und wenn mit der Oberflächenspulen-Anordnung 10 empfangen werden soll, wird die Körperspulen-Anordnung 9 verstimmt. Dadurch sind diese Spulen-Anordnungen induktiv voneinander entkoppelt.

Fig. 2 zeigt die räumliche Lage der Spulen-Anordnung 9, bei der es sich z.B. um eine Spule vom Bird-Cage-Typ handeln kann, sowie die aus mehreren (im Beispiel vier) einzelnen Oberflächenspulen 101...104 bestehende Oberflächenspulen-Anordnung. Die vier Oberflächenspulen 101 bis 104 können auf einem nicht näher dargestellten flexiblen Träger angeordnet sein, der um den Patienten herum gewickelt wird. Die Spulen sind dabei so auf dem Träger angeordnet, daß sie sich in einem definierten Bereich überlappen, so daß sich eine gute Entkopplung zwischen diesen Oberflächenspulen ergibt. Zwischen der Oberflächenspulen-Anordnung 10 bzw. 101...104 einerseits und der Körperspulen-Anordnung 9 andererseits ist jedoch eine Entkopplung nicht erreichbar.

Wie bereits erwähnt, haben die Oberflächenspulen 101...104 eine örtlich inhomogene Empfindlichkeit, d.h. ein im Zentrum des Untersuchungsobjekts 12 entstehendes MR-Signal ruft in den Spulen einen anderen Strom hervor als ein an der Oberfläche des Untersuchungsobjekts entstehendes MR-Signal gleicher Größe. Um diese Empfindlichkeitsunterschiede auszugleichen, werden daher zusätzlich zu MR-Untersuchung noch eine erste MR-Hilfsmessung mit der Körperspulen-Anordnung 9 und eine zweite MR-Hilfsmessung mit der Oberflächenspulen-Anordnung 10 durchgeführt. Aus diesen beiden Hilfsmessungen werden, wie weiter unten noch erläutert wird, Hilfswerte abgeleitet, mit denen die bei der MR-Untersuchung gewonnenen MR-Daten korrigiert werden.

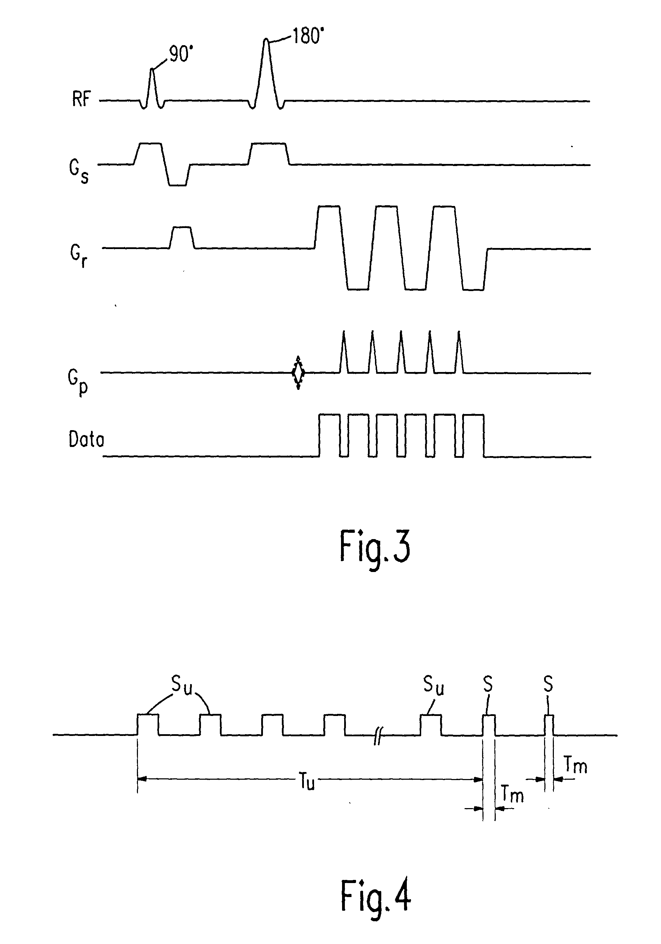

In Fig. 3 ist eine Sequenz vom EPI-Typ dargestellt, mit der die MR-Untersuchung durchgeführt werden kann. Die erste Zeile von Fig. 3 zeigt den zeitlichen Verlauf der Hochfrequenzimpulse bei einer solchen Sequenz. Dabei folgt auf einen $90°$-Hochfrequenzimpuls ein refokussierender $180°$-Impuls. Beide Hochfrequenzimpulse sind schichtselektiv, d.h., sie werden von einem magnetischen Gradientenfeld $G_s$ begleitet, das in der zweiten Zeile von Fig. 3 dargestellt ist. Dadurch wird lediglich die Kernmagnetisierung in einer Schicht beeinflußt.

Die im Untersuchungsbereich entstehenden MR-Signale werden in Verbindung mit einem alternierenden Lesegradienten $G_r$ und ausgelesen, dessen zeitlicher Verlauf in der dritten Zeile von Fig. 3 dargestellt ist. Der Lesegradient hat dabei während eines kleinen Zeitintervalls einen positiven konstanten Wert und ändert sich dann rampenförmig auf einen dem Betrage nach gleichen negativen konstanten Wert, um dann wieder positiv zu werden usw. Jeweils während des Übergangs zwischen dem positiven und dem negativen Wert ist ein Phasenkodierungsgradient $G_p$ wirksam (vierte Zeile von Fig. 3).

Durch diesen zeitlichen Verlauf von $G_r$ und $G_p$ werden jeweils mehrere in Richtung des Lesegradienten $G_r$ verlaufende und parallel zueinander versetzte Linien im k-Raum abgetastet. Jeweils während des Abtastens einer dieser Linien (d.h., wenn der Lesegradient konstant ist), werden die als Echo auftretenden MR-Signale ausgelesen und verarbeitet, wie in der fünften Zeile von Fig. 3 dargestellt.

Anstelle der in Fig. 3 dargestellten EPI-Sequenz können auch beliebige andere - auch länger dauernde - Sequenzen bei der MR-Untersuchung angewandt werden.

Die von der Oberflächenspulen-Anordnung bei dieser MR-Untersuchung aufgenommenen MR-Signale werden von der Empfangs- und Verarbeitungseinheit 8 zu je einem MR-Bild für jede der in der Anordnung 10 enthaltenen Oberflächenspulen verarbeitet. Die ortsabhängigen, für die einzelnen Bildpunkte dieser hoch aufgelösten MR-Bilder ermittelten Bildwerte werden im folgenden mit $H_i$ bezeichnet, wobei der Index i die Oberflächenspule 101...104 kennzeichnet, mit der das MR-Bild aufgenommen wurde. Selbst wenn das Untersuchungsobjekt 12 vollständig isotrope Eigenschaften hätte, würden die so gebildeten Werte wegen der ortsabhängigen Spulenempfindlichkeit von der Lage des jeweiligen Bildpunkts abhängen.

Daher werden nachfolgend (oder vorher) zwei MR-Hilfsmessungen durchgeführt, mit denen die Ortsabhängigkeit der Empfindlichkeit der Oberflächenspulen-Anordnung ermittelt werden soll. Da sich die Empfindlichkeit als Funktion des Ortes nur relativ langsam ändert, ist eine geringe räumliche Auflösung (z.B. 32 x 32) ausreichend.

Dafür wird nur eine geringe Zahl von MR-Echos benötigt. Deshalb ist es möglich, mit einer einzigen Sequenz (Single-Shot-EPI) auszukommen, die sich von der anhand von Fig. 3 als Beispiel erläuterten Sequenz im Prinzip nur dadurch unterscheidet, daß sie nicht wiederholt zu werden braucht. Die Sequenz dauert dann z.B. nur 45 ms. Durch die Sequenz wird die Kernmagnetisierung in der gleichen oder einer benachbarten Schicht angeregt wie bei der MR-Untersuchung.

Eine derartige MR-Hilfsmessung wird einerseits mit der Oberflächenspulen-Anordnung 10 durchgeführt und andererseits mit der Körperspulen-Anordnung 9. Aus den von der Oberflächenspulen-Anordnung 10 erzeugten MR-Signalen erzeugt die Empfangs- und Verarbeitungseinheit 8 pro Oberflächenspule ein MR-Bild. Die Bildwerte der Bildpunkte in diesem niedrig aufgelösten MR-Bild werden mit $L_i$ bezeichnet, wobei der Index i die jeweilige Oberflächenspule kennzeichnet. Die Bildwerte des mittels der Körperspulen-Anordnung erzeugten (ebenfalls niedrig aufgelösten) MR-Bildes werden mit B bezeichnet.

Bei einem ersten Verfahren zur Korrektur der aus der MR-Untersuchung gewonnenen MR-Bilddaten werden zunächst für jeden Bildpunkt der bei der MR-Hilfsmessungen mit der Oberflächenspulen-Anordnung gewonnenen MR-Bilder die Bildwerte L' eines MR-Überlagerungsbildes nach der Gleichung

$$L' = \sqrt{\sum_i L_i^2} \qquad\qquad (1)$$

als Quadratwurzel aus der Summe der Quadrate der von den einzelnen Spulen der Oberflächenspulen-Anordnung für den betreffenden Bildpunkt gelieferten Bildwerte $L_i$ berechnet. Das aus den Bildwerten L' zusammengesetzte und eine niedrige Auflösung aufweisende MR-Überlagerungsbild ist - wie die MR-Bilder, aus denen es abgeleitet wird - ortsabhängig empfindlich.

Analog dazu werden aus den MR-Bildwerten $H_i$, die zu den bei der MR-Untersuchung gewonnenen, hoch aufgelösten MR-Bildern für jeweils eine Spule gehören, die Bildwerte H' eines hoch aufgelösten MR-Überlagerungsbildes berechnet nach der Beziehung:

$$H' = \sqrt{\sum_i H_i^2} \qquad\qquad (2)$$

Die Bildwerte L', H' sind zwar noch nicht hinsichtlich der ortsabhängigen Empfindlichkeit der Oberflächenspulen-Anordnung korrigiert, jedoch ist infolge der Summierung über die Quadrate der von den einzelnen Spulen der Oberflächenspulen-Anordnung gelieferten Bildwerte $L_i$ bzw. $H_i$ der Einfluß der kleinen (d.h. mit einem relativ starken Rauschen behafteten) Bildwerte reduziert.

Die Korrektur erfolgt mittels eines Kalibrationsfaktors C, der aus den gemäß Gleichung (1) berechneten Werten L' sowie aus den Bildwerten B des aus der MR-Hilfsmessung mit der Körperspulen-Anordnung erzeugten MR-Bildes nach der Gleichung

$$C = \frac{L' \cdot B}{|L'|^2 + r_1} \qquad\qquad (3)$$

berechnet wird. Der Summand $r_1$ im Nenner ist dabei ein Regularisierungsparameter, der den Einfluß des Rauschens für diejenigen Bildpunkte zurückdrängt, die einer Region im Untersuchungsbereich zugeordnet sind, in der nur schwache oder keine MR-Signale entstehen.

Mit diesen Hilfswerten und den gemäß Gleichung (2) berechneten Bildwerten H' werden die Bildwerte H eines hoch aufgelösten und hinsichtlich der ortsabhängigen Empfindlichkeit der Oberflächenspulen-Anordnung korrigierten MR-Überlagerungsbildes berechnet nach der Formel

$$H = C \cdot H' \qquad\qquad (4)$$

Das aus den Bildwerten H gebildete MR-Bild ist zwar weitgehend unbeeinflußt von der örtlich inhomogenen Empfindlichkeit der Oberflächenspulen, doch ist es hinsichtlich des Signal/Rauschverhältnisses noch nicht optimal.

Ein in dieser Hinsicht verbessertes Verfahren beruht auf einer Vereinfachung der von Römer et al (Magn. Reson. Med. 16, 192, 1990) angegebenen Formel:

$$H = C \cdot \sum_i a_i^* \cdot H_i \qquad \text{mit} \quad 1 \le i \le i_{max} \qquad (5)$$

Dabei ist $i_{max}$ die Zahl der Oberlächenspulen, und C ist eine den globalen Helligkeitsausgleich herbeiführende Helligkeitsfunktion bzw ein ortabhängiger Kalibrationsfaktor, $a_i^*$ ist der zu der (komplexen) Emfindlichkeitsverteilung $a_i$ der Oberflächenspule i konjugiert komplexe Wert. Die ortsabhängige Faktoren C und $a_i$ werden aus den MR-Hilfsmessungen errechnet werden. Für $a_i$ gilt dabei:

$$a_i = \frac{L_i \cdot B^*}{|B'|^2 + r_2} \qquad (6)$$

$L_i$ bezeichnet den Bildwert der i-ten Oberflächenspule für den jeweiligen Bildpunkt und B den von der Körperspulen-Anordnung für denselben Bildpunkt gebildeten Bildwert. B* ist der zu B konjugiert komplexe Wert, und $r_2$ ist ein weiterer positiver Regularisierungsparameter.

Wenn die Oberflächenspulen-Anordnung nur durch eine einzige Spule gebildet würde und wenn r = 0 wäre, dann würde die nach Gleichung (6) berechnete Empfindlichkeit $a_1$ (bei einer einzigen Spule ist i = 1) dieser Spule übergehen in $a_1 = L_1/B$.

Wenn alle Werte B stark vom Rauschen korrumpiert sind - beispielsweise deshalb, weil in dem Körperbereich des Patienten, der dem betreffenden Bildpunkt zugeordnet ist, keine Protonen sondern Luft vorhanden ist, wird der Einfluß des Rauschens durch den Regularisierungsparameter $r_2$ zurückgedrängt. Dieser Parameter soll daher so gewählt sein, daß sich sein Einfluß auf $a_i$ nur für diejenigen Bildpunkte bemerkbar macht, in denen aufgrund der Kernmagnetisierungsverteilung bzw. der Protonendichte im Körper nur ein geringes oder kein MR-Signal entstehen kann.

Nachdem auf diese Weise aus den MR-Bildern, die aus den beiden MR-Untersuchungen resultieren, für jede Spule der Oberflächenspulen-Anordnung -Anordnung und für jeden Bildpunkt Werte $a_i$ gemäß Gleichung (6) ermittelt worden sind, werden die zugehörigen Bildwerte $H_i$ dieser hoch aufgelösten MR-Bilder mit dem für den betreffenden Bildpunkt geltenden Wert $a_i$ multipliziert und komplex summiert, so daß sich ein MR-Überlagerungsbild H' nach der Formel ergibt :

$$H' = \sum_i a_i^* \cdot H_i \qquad (7)$$

Ein aus den Werten H' gebildetes MR-Bild besitzt zwar ein verbessertes Signal/Rausch-Verhältnis, aber noch keine ausgeglichene Helligkeitsverteilung. Um diese Helligkeitsverteilung zu erhalten, werden aus den bei der MR-Hilfsmessung mit der Oberlächenspulen-Anordnung gewonnenen MR-Daten $L_i$ analog zu Gleichung (7) Werte L' berechnet nach der Gleichung

$$L' = \sum_i a_i^* \cdot L_i \qquad (8)$$

Aus den Werten L', die in gleicher Weise von der örtlich inhomogenen Empfindlichkeit der Oberflächenspulen beeinflußt sind wie die Werte H', wird nun nach der Beziehung:

$$C = \frac{L'^* \cdot B}{|L'|^2 + r_3} \qquad (9)$$

der der Helligkeitsfunktion entsprechende Kalibrationsfaktor C berechnet, wobei L'* der zu L' konjugiert komplexe Wert

ist und $r_3$ wiederum ein geeignet gewählter Regularisierungsparameter ist. Damit ergibt sich ein kalibriertes Überlagerungsbild nach der Beziehung:

$$H = C \cdot H' \qquad (10)$$

In Figur 4 ist nochmals die gesamte zeitliche Abfolge für die MR-Untersuchung und für die beiden MR-Hilfsmessungen dargestellt. Die MR-Untersuchung besteht aus mehreren Sequenzen $S_u$, deren zeitlicher Verlauf sich jeweils aus Fig. 3 ergibt. Wie bereits erwähnt, wird die Dauer $T_u$ der MR-Untersuchung weniger von der Dauer der einzelnen Sequenz $S_u$ als von der Zahl dieser Sequenzen und dem zeitlichen Abstand bestimmt, in dem sie aufeinander folgen. Für die MR-Hilfsmessung mit der Oberflächenspulen-Anordnung einerseits und der Körperspulen-Anordnung andererseits, bei der jeweils nur eine einzige Sequenz S auf den Untersuchungsbereich einwirkt, ergibt sich nur eine kurze Dauer $T_m$, und die dadurch bedingte Verlängerung der MR-Meßzeit entspricht dabei praktisch nur dem zeitlichen Abstand zwischen den beiden Sequenzen (ca. 1 bis 2 s). Obwohl also insgesamt dreimal MR-Signale zur Erzeugung von MR-Bildern erfaßt werden, ist die dafür benötigte Zeit nur unwesentlich länger als die Zeit $T_u$, die für die MR-Untersuchung allein benötigt wird. Auch ist die HF-Belastung für den Patienten nur unwesentlich vergrößert, weil bei den beiden MR-Hilfsmessungen nur zwei Sequenzen - und damit wesentlich weniger als bei der MR-Untersuchung - auf den Untersuchungsbereich einwirken.

An sich können die Sequenz $S_u$ und S in beliebiger Reihenfolge auftreten; jedoch ist es zweckmäßig, die Sequenzen S für die beiden MR-Hilfsmessungen unmittelbar aufeinander folgen zu lassen.

Wenn von einer Anzahl dicht benachbarter und paralleler Schichten im Untersuchungsbereich ein hoch aufgelöstes MR-Bild erstellt werden soll, dann ist es nicht erforderlich, für jede dieser Schichten zwei MR-Hilfsmessungen durchzuführen. Die Hilfswerte a bzw $a_i$ ändern sich als Funktion des Ortes nur allmählich, so daß sie über einen Bereich, in dem sich die Spulenempfindlichkeiten nicht zu stark ändern benutzt werden können. Dazu sollten sie vorzugsweise aus an relativ dicken Schichten vorgenommenen MR-Hilfsmessungen abgeleitet werden. Das gleiche gilt, wenn eine hochaufgelöste dreidimensionale MR-Hilfsmessung durchgeführt werden soll.

Wenn von einem Untersuchungsbereich eine zeitliche Folge von MR-Bildern gewonnen werden soll, ist es ebenfalls nicht nötig, die MR-Hilfsmessungen zu wiederholen. Solange sich die zugrundeliegende Spulengeometrie nicht ändert, können die einmal bestimmte Hilfswerte C und $a_i$ weiterbenutzt werden. Dies schließt auch den Fall ein, daß unterschiedliche MR-Sequenzen zu Erzeugung der hochaufgelösten MR-Bilder herangezogen werden.

**Patentansprüche**

1. MR-Verfahren zur Bestimmung der Kernmagnetisierungsverteilung in einem Untersuchungsbereich (12), bei dem die bei einer MR-Untersuchung mit Hilfe einer mindestens eine Spule (101...104) enthaltenden Oberflächenspulen-Anordnung (10) mit örtlich inhomogener Empfindlichkeit gewonnenen Bild-Daten ($H_i$) aufgrund von Hilfswerten ($a_i$) korrigiert werden, die aus den mit Hilfe einer Körper-Spulenanordnung (9) mit örtlich zumindest näherungsweise homogener Empfindlichkeit gewonnenen Daten abgeleitet werden,
   **dadurch gekennzeichnet, daß** zusätzlich zur MR-Untersuchung je eine MR-Hilfsmessung mit der Oberflächenspulen-Anordnung (10) und mit der Körper-Spulenanordnung (9) erfolgt, daß die beiden MR-Hilfsmessungen zeitlich getrennt voneinander und von der MR-Untersuchung erfolgen, daß während der beiden MR-Hilfsmessungen die auf den Untersuchungsbereich einwirkenden Magnetfelder den gleichen zeitlichen Verlauf haben und daß die Hilfswerte ($a_i$) aus den bei den beiden MR-Hilfsmessungen gewonnen Daten abgeleitet werden.

2. MR-Verfahren nach Anspruch 1,
   **dadurch gekennzeichnet, daß** aus den bei der MR-Hilfsmessung mit der Oberflächenspulen-Anordnung (10) einerseits und aus den bei der MR-Untersuchung andrerseits gewonnen Daten ($L_i$ bzw $H_i$) MR-Überlagerungsbilder (L' bzw H') errechnet werden, die in gleicher Weise von der ortsabhängigen Empfindlichkeit der Oberflächenspulen-Anordnung (10) abhängen, und daß aus der Relation des aus der MR-Hilfsmessung erhaltenen MR-Überlagerungsbildes (L') zu dem aus der MR-Hilfsmessung mit der Körperspulen-Anordnung (9) gewonnenen MR-Bild (B) Hilfswerte (C) gewonnen werden, mittels derer das aus der MR-Untersuchung abgeleitete MR-Überlagerungsbild (H') korrigiert wird.

3. MR-Verfahren nach Anspruch 2,
   **dadurch gekennzeichnet, daß** die MR-Überlagerungsbilder (L' bzw H') durch gewichtete Summierung der von den einzelnen Spulen der Oberflächenspulen-Anordnung (10) ermittelten MR-Bilder gebildet werden, wobei die Gewichtungsfaktoren ($a_i$), mit denen die MR-Bilddaten ($L_i$ bzw $H_i$) der einzelnen MR-Bilder in die Summierung eingehen, aus der Relation der bei den beiden MR-Hilfsmessungen jeweils für den gleichen Bildpunkt gewonnenen MR-Bilddaten ($L_i$, B) abgeleitet werden.

**4.** MR-Verfahren nach Anspruch 1,
**dadurch gekennzeichnet, daß** die MR-Hilfsmessungen für eine geringere räumliche Auflösung ausgelegt sind als die MR-Untersuchung.

**5.** MR-Verfahren nach Anspruch 1,
**dadurch gekennzeichnet, daß** die Meßzeit für jede der beiden MR-Hilfsmessungen kleiner ist als die für die MR-Untersuchung benötigte Meßzeit

**6.** MR-Anordnung zu Durchführung des Verfahrens nach Anspruch 1, umfassend

a) eine mindestens eine Spule (101...104) umfassende Oberflächenspulen-Anordnung (10)
b) eine Körperspulen-Anordnung (9) mit örtlich zumindest näherungsweise homogener Empfindlichkeit
c) Verarbeitungsmittel (8) zur Erzeugung von MR-Bildern aus den von der Oberflächenspulen-Anordnung und von der Körperspulen-Anordnung empfangenen MR-Signalen sowie zum Ableiten von Hilfswerte aus den MR-Bildern
d) programmierbare Steuermittel (5) zum Steuern des zeitlichen Verlaufs der auf den Untersuchungsbereich einwirkenden Magnetfelder und der MR-Signalverarbeitung,

**dadurch gekennzeichnet, daß** die Steuermittel (5) so programmiert sind, daß zeitlich von einander getrennt eine MR-Untersuchung (10) und eine MR-Hilfsmessung mit der Oberflächenspulen-Anordnung und eine MR-Hilfsmessung mit der Körperspulen-Anordnung durchgeführt werden, wobei die während der beiden MK-Hilfsmessungen auf den Untersuchungsbereich einwirkenden Magnetfelder den gleichen zeitlichen verlauf haben und daß die Verarbeitungsmittel (8) so eingerichtet sind, daß sie aus den bei den MR-Hilfsmessungen gewonnenen Daten Hilfswerte (9) gewinnen, mit denen die bei der MR-Untersuchung gewonnenen Bild-Daten ($H_i$) korrigiert werden.

**7.** Anordnung nach Anspruch 6,
**dadurch gekennzeichnet, daß** die Oberflächenspulen-Anordnung (10) und die Körperspulen-Anordnung (9) in einem Empfangs-Modus, in dem sie MR-Signale aufnehmen können, und in einem Entkopplungs-Modus betreibbar sind, in dem sie keine MR-Signale aufnehmen können, und daß die Moden durch die Steuermittel (5) so gesteuert sind, daß die Körperspulen-Anordnung (10) im Entkopplungsmodus betrieben wird, wenn die Oberflächenspulen-Anordnung (9) im Empfangs-Modus betrieben wird - und umgekehrt.

**Claims**

**1.** An MR method for determining the nuclear magnetization distribution in an examination zone (12), in which the image data ($H_i$), acquired during an MR examination by means of a surface coil arrangement (10) comprising at least one coil (101 ... 104) and having a locally inhomogeneous sensitivity, are corrected on the basis of auxiliary values (a;) derived from the data acquired by means of a body coil arrangement (9) having a locally at least approximately homogeneous sensitivity,
**characterized in that** in addition to the MR examination a respective MR auxiliary measurement is carried out by means of the surface coil arrangement (10) as well as by means of the body coil arrangement (9), **in that** the two MR auxiliary measurements are carried out temporally separately from one another and from the MR examination, **in that** during the two MR auxiliary measurements the magnetic fields acting on the examination zone exhibit the same temporal variation, and **in that** the auxiliary values ($a_i$) are derived from the data acquired during the two MR auxiliary measurements.

**2.** An MR method as claimed in Claim 1,
**characterized in that** MR superposition images (L' and H') are calculated from the data (L; and $H_i$) acquired during the MR auxiliary measurement by means of the surface coil arrangement (10) on the one hand and from those acquired during the MR examination on the other hand, which MR superposition images are dependent on the location-dependent sensitivity of the surface coil arrangement (10) in the same way, and **in that** auxiliary values (C) are derived from the relation of the MR superposition image (L') obtained from the MR auxiliary measurement to the MR image (B) obtained from the MR auxiliary measurement by means of the body coil arrangement (9), which auxiliary values are used to correct the MR superposition image (H') derived from the MR examination.

EP 0 695 947 B1

3. An MR method as claimed in Claim 2,
**characterized in that** the MR superposition images (L' and H') are formed by weighted summing of the MR images determined by the individual coils of the surface coil arrangement (10), the weighting factors (a;) that are applied to the MR image data (L; and $H_i$) of the individual MR images to be summed being derived from the relation of the respective MR image data ($L_i$, B) determined for the same pixel during the two MR auxiliary measurements.

4. An MR method as claimed in Claim 1, **characterized in that** the MR auxiliary measurements are conceived for a spatial resolution lower than that for the MR examination.

5. An MR method as claimed in Claim 1, **characterized in that** the measuring time for each of the two MR auxiliary measurements is smaller than the measuring time required for the MR examination.

6. An MR device for carrying out the method claimed in Claim 1, comprising

a) a surface coil arrangement (10) which comprises at least one coil (101 ... 104),
b) a body coil arrangement (9) of locally at least approximately homogeneous sensitivity,
c) processing means (8) for forming MR images from the MR signals received from the surface coil arrangement and from the body coil arrangement as well as for deriving auxiliary values from the MR images,
d) programmable control means (5) for controlling the variation in time of the magnetic fields acting on the examination zone and for controlling the MR signal processing,

**characterized in that** the control means (5) are programmed in such a manner that an MR examination (10), an MR auxiliary measurement by means of the surface coil arrangement, and an MR auxiliary measurement by means of the body coil arrangement are carried out temporally separately, the magnetic fields acting on the examination zone during the two MR auxiliary measurements exhibiting the same temporal variation, and that the processing means (8) are arranged so that they derive auxiliary values (9) from the data acquired during the MR auxiliary measurements, said auxiliary values being used to correct the image data ($H_i$) acquired during the MR examination.

7. A device as claimed in Claim 6,
**characterized in that** the surface coil arrangement (10) and the body coil arrangement (9) can operate in a receiving mode in which they can pick up MR signals and in a decoupling mode in which they cannot pick up MR signals, and that the modes are controlled by the control means (5) in such a manner that the body coil arrangement (10) operates in the decoupling mode when the surface coil arrangement (9) operates in the receiving mode, and *vice versa.*

**Revendications**

1. Procédé RM en vue de la détermination de la distribution de la magnétisation nucléaire dans une zone d'examen (12), dans lequel les données d'image ($H_i$) obtenues lors d'un examen RM à l'aide d'un dispositif de bobines de surface (10) contenant au moins une bobine (101...104) avec une sensibilité localement inhomogène sont corrigées en fonction de valeurs auxiliaires ($a_i$) qui sont dérivées des données obtenues à l'aide d'un dispositif de bobines de corps entier (9) avec une sensibilité localement homogène, du moins approximativement,
**caractérisé en ce qu'**en plus de l'examen RM, une mesure auxiliaire RM est respectivement effectuée avec le dispositif de bobines de surface (10) et avec le dispositif de bobines de corps entier (9), que les deux mesures auxiliaires RM sont espacées dans le temps l'une par rapport à l'autre et par rapport à l'examen RM de telle sorte que, pendant les deux mesures auxiliaires RM, les champs magnétiques agissant sur la zone d'examen présentent le même tracé temporel et que les valeurs auxiliaires ($a_i$) soient dérivées des données obtenues lors des deux mesures auxiliaires RM.

2. Procédé RM selon la revendication 1,
**caractérisé en ce que** des images de superposition RM (L', ou H') qui dépendent de la même manière de la sensibilité spatiale du dispositif de bobines de surface (10) sont formées à partir des données ($L_i$ ou $H_i$) obtenues lors de la mesure auxiliaire RM avec le dispositif de bobines de surface (10), d'une part, et lors de l'examen RM, d'autre part, et qu'à partir de la relation de l'image de superposition RM (L') obtenue lors de la mesure auxiliaire RM et l'image RM (B) lors de la mesure auxiliaire RM avec le dispositif de bobines de corps entier (9) sont obtenues des valeurs auxiliaires (C) à l'aide desquelles l'image de superposition RM (H') dérivée de l'examen RM est corrigée.

**3.** Procédé RM selon la revendication 2,
**<u>caractérisé en ce</u> que** les images de superposition RM (L' ou H') sont formées par addition pondérée des images RM déterminées par les différentes bobines du dispositif de bobines de surface (10), les facteurs de pondération ($a_i$) avec lesquels les données d'image RM ($L_i$ ou $H_i$) des différentes images RM sont prises en considération dans l'addition sont dérivés de la relation des données d'image RM ($L_i$, B) obtenues respectivement lors des deux mesures auxiliaires RM pour le même point d'image.

**4.** Procédé RM selon la revendication 1,
**<u>caractérisé en ce</u> que** les mesures auxiliaires RM sont conçues pour une résolution spatiale inférieure à celle de l'examen RM.

**5.** Procédé RM selon la revendication 1,
**<u>caractérisé en ce</u> que** le temps de mesure pour chacune des deux mesures auxiliaires RM est inférieur au temps de mesure nécessaire pour l'examen RM.

**6.** Dispositif RM de mise en oeuvre du procédé selon la revendication 1, comprenant :

a) un dispositif de bobines de surface (10) comprenant au moins une bobine (101...104),
b) un dispositif de bobines de corps entier (9) avec une sensibilité homogène spatialement, du moins approximativement,
c) des moyens de traitement (8) pour produire des images RM à partir des signaux RM reçus par le dispositif de bobines de surface et le dispositif de bobines de corps entier ainsi que pour dériver des valeurs auxiliaires des images RM;
d) des moyens de commande programmables (5) en vue de la commande du déroulement temporel des champs magnétiques agissant sur la zone d'examen et du traitement des signaux RM,

**<u>caractérisé en ce</u> que** les moyens de commande (5) sont programmés de telle sorte qu'un examen RM (10) et une mesure auxiliaire RM avec le dispositif de bobines de surface et une mesure auxiliaire RM avec le dispositif de bobines de corps sont effectués dans un intervalle temporel, les champs magnétiques agissant pendant les deux mesures auxiliaires RM sur la zone d'examen présentant le même tracé temporel, et que les moyens de traitement (8) sont agencés de telle sorte que des valeurs auxiliaires (9) à l'aide desquelles les données d'image ($H_i$) obtenues lors de l'examen RM doivent être corrigées à partir des données obtenues lors des mesures auxiliaires RM.

**7.** Dispositif selon la revendication 6,
**<u>caractérisé en ce</u> que** le dispositif de bobines de surface (10) et le dispositif de bobines de corps (9) peuvent être actionnés dans un mode de réception dans lequel ils peuvent enregistrer des signaux RM et dans un mode de découplage dans lequel ils ne peuvent enregistrer de signaux RM et que les modes sont commandés par les moyens de commande (5) de telle sorte que le dispositif de bobines de corps entier (10) soit commuté en mode de découplage lorsque le dispositif de bobines de surface (9) est commuté en mode de réception et inversement.

Fig.1

Fig.2

Fig.3

Fig.4